# EUROPEAN PATENT APPLICATION

(11) **EP 4 658 028 A1**
(43) Date of publication of application: **03.12.2025**
(21) Application number: 25177614.2
(22) Date of filing: 20.05.2025
(51) Int. Cl.: H10F 19/90, H10F 77/14, H10F 19/37

(54) **SOLAR MODULE**

(30) Priority: 21.05.2024 TW 113118779
(71) Applicant: Heliartec Solutions Corporation, Ltd., Zhubei City 302044 (TW)
(72) Inventor: HSU, Chien-Chung, 302044 Zhubei City (TW); HUANG, Ting-Hui, 302044 Zhubei City (TW)
(74) Representative: Viering, Jentschura & Partner mbB Patent- und Rechtsanwälte

(57) **Abstract**

A solar module includes a plurality of solar cells and a carrier plate. The carrier plate includes a front cover and a back cover. The plurality of solar cells are welded and connected in series to define a plurality of solar battery string groups. The plurality of solar cells are connected in series at a predetermined spacing distance therebetween in a first direction to form each of the plurality of solar battery string groups. A width of each of the plurality of solar cells in the first direction is a first length, a length of each of the plurality of solar cells in a second direction is a second length, and a ratio of the second length to the first length is greater than 10. The plurality of solar battery string groups are pressed between the front cover and the back cover via a plurality of bus strips.

## Description

### BACKGROUND

### 1. Technical Field

The present disclosure relates to the technical field of solar energy, and more particularly, to a solar module.

### 2. Description of Related Art

In response to the global trend of near-zero energy consumption buildings, the technology of integrating solar energy into building structures is becoming more and more prevalent. However, solar modules integrated in buildings and used in translucent glass building curtains or lighting fences of balconies must be visually transparent.

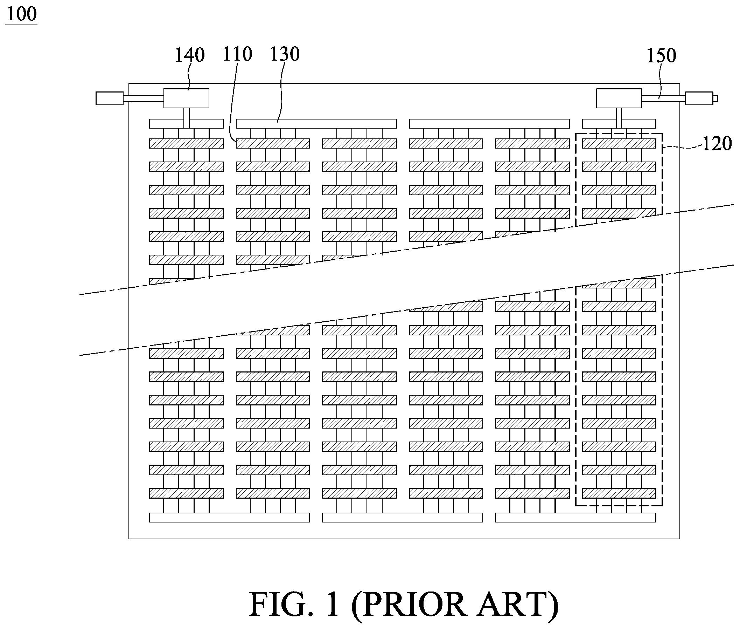

As shown in FIG. 1, in a layout of the conventional see-through silicon crystal solar module cell, a solar module 100 includes rectangular cells 110, battery strings 120, bus strips 130, junction boxes 140 and cables 150, wherein after a silicon crystal solar cell is cut into rectangular cells 110, the rectangular cells 110 are then connected in series to form a battery string 120, and each battery string 120 is welded together in series to form an internal circuit of the solar module 100. However, due to the influence of the width of the solar module, the total number of series groups of rectangular cells 110 is often too large, causing the series voltage to be too high. Or in order to avoid excessively high series voltage, the total number of narrow-width rectangular cells 110 in series must be reduced. Therefore, it is quite difficult to use the conventional rectangular cell module as a see-through solar module 100 in practical applications.

Therefore, how to overcome the various deficiencies of the above-mentioned prior art has become an urgent problem that needs to be overcome in the industry.

### SUMMARY

In view of the deficiencies in the above-mentioned prior art, the present disclosure is to solve the technical problems encountered in the above-mentioned conventional see-through solar modules. The new solar cell layout design method can concurrently improve the transparency and output power of solar modules. The present disclosure provides a solar module, which comprises: a plurality of solar cells, wherein the plurality of solar cells are welded and connected in series to define a plurality of solar battery string groups, and the plurality of solar cells are connected in series with a predetermined spacing distance therebetween in a first direction to form each of the plurality of solar battery string groups, wherein a width of each of the plurality of solar cells in the first direction is a first length, a length of each of the plurality of solar cells in a second direction is a second length, and a ratio of the second length to the first length is greater than 10; and a carrier plate including a front cover and a back cover, wherein the plurality of solar battery string groups are pressed in series or in parallel between the front cover and the back cover via a plurality of bus strips, wherein the plurality of solar battery string groups on both sides of each of the plurality of bus strips are connected in series, and the plurality of solar battery string groups are connected in parallel between any two of the plurality of bus strips.

In the aforementioned solar module, the front cover, the back cover and the plurality of solar battery string groups have an adhesive intermediate film therebetween.

In the aforementioned solar module, the front cover and the back cover are made of transparent material.

In the aforementioned solar module, the transparent material is glass or resin.

In the aforementioned solar module, the first length is greater than 7 mm.

In the aforementioned solar module, a total number of the plurality of solar cells in each of the plurality of solar battery string groups does not exceed 100.

In the aforementioned solar module, the predetermined spacing distance is less than 3 mm.

In the aforementioned solar module, the solar module further comprises at least one bypass diode electrically connected between any two of the plurality of bus strips.

In the aforementioned solar module, the solar module further comprises: a cable electrically connected to one end of the at least one bypass diode; and a terminal electrically connected to the other end of the at least one bypass diode.

As can be seen from the above, in the solar module of the present disclosure, each of the solar cells is cut to have a ratio of the second length to the first length greater than 10, and the solar cells are connected in series at a predetermined spacing distance therebetween in the first direction to form solar battery string groups, so that the visual appearance will not be affected when the solar module of the present disclosure is applied to glass building curtains. In addition, a plurality of bus strips are arranged in the carrier plate of the solar module area to combine the plurality of solar battery string groups in series/parallel connection, thereby meeting the output voltage and current requirements of the solar module to increase the output power. At the same time, a bypass diode is welded between any two of the bus strips to protect each solar battery string group.

### BRIEF DESCRIPTION OF THE DRAWINGS

FIG. 1 is a schematic diagram of a conventional see-through silicon crystal solar module.
FIG. 2 is a schematic diagram of cutting a complete square silicon wafer into solar cells according to the present disclosure.
FIG. 3 is a schematic diagram of the solar cells of the present disclosure being welded and connected in series to form a solar battery string group.
FIG. 4 is a schematic diagram of a welding method of the solar battery string group and the bus strip according to the present disclosure.
FIG. 5 is a schematic diagram of the present disclosure applied to a see-through silicon crystal solar module.

### DETAILED DESCRIPTION

The following describes the implementation of the present disclosure with examples. Those skilled in the art can easily understand other advantages and effects of the present disclosure from the contents disclosed in this specification.

It should be understood that, the structures, ratios, sizes, and the like in the accompanying figures are used for illustrative purposes to facilitate the perusal and comprehension of the contents disclosed in the present specification by one skilled in the art, rather than to limit the conditions for practicing the present disclosure. Any modification of the structures, alteration of the ratio relationships, or adjustment of the sizes without affecting the possible effects and achievable proposes should still be deemed as falling within the scope defined by the technical contents disclosed in the present specification. Meanwhile, terms such as "on," "upper," "lower," "front," "back," "left," "right," "first," "second," "a," "one" and the like are merely for clear explanation rather than limiting the practicable scope of the present disclosure, and thus, alterations or adjustments of the relative relationships thereof without essentially altering the technical contents should still be considered in the practicable scope of the present disclosure.

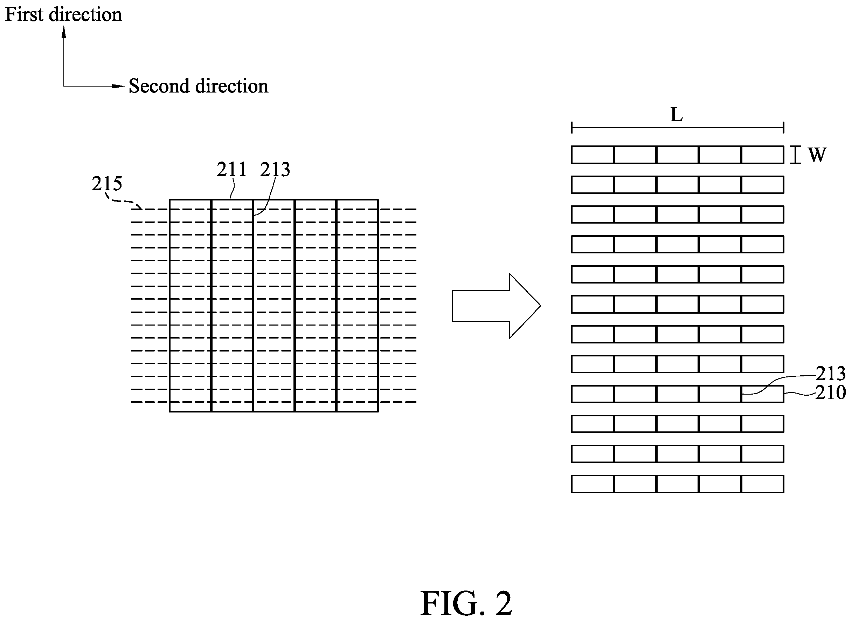

FIG. 2 is a schematic diagram of cutting a complete square silicon wafer into a plurality of solar cells according to the present disclosure. As shown in FIG. 2, a complete square (or rectangular) silicon crystal cell 211 is laser cut into a plurality of narrow-width solar cells 210. The vertical interval lines are solar cell main grid lines 213, and the horizontal dotted lines are laser cutting tracks 215 after the laser cutting process. The width of each solar cell 210 in the first direction is the first length W, and the length of each solar cell 210 in the second direction is the second length L. For example, the first length W is greater than 7 mm. In other embodiments, the first length W may be greater than 8 mm, 9 mm, or 11 mm. The extent of the first length W is adjusted according to the overall solar battery output power and the overall area, and the ratio of the second length L to the first length W is greater than 10. In other words, L/W > 10, such a size design can laser cut more solar cells 210, and can effectively increase the output power of the overall solar battery.

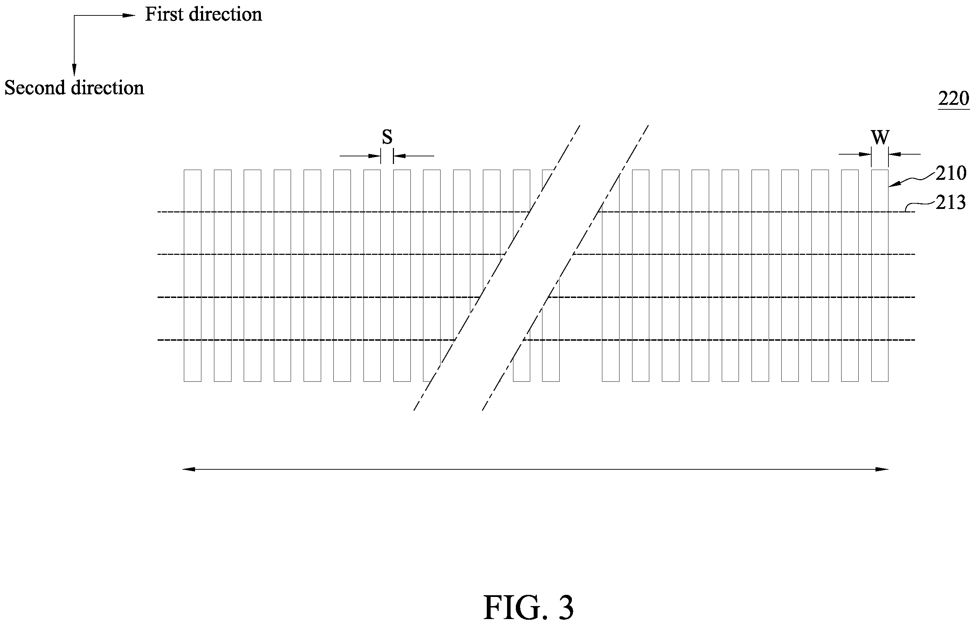

FIG. 3 is a schematic diagram of the solar cells of the present disclosure being welded and connected in series to form a solar battery string group. A plurality of solar cells 210 are welded and connected in series to define a solar battery string group 220. A plurality of solar cells 210 are connected in series with a predetermined spacing distance S therebetween in the first direction to form a solar battery string group 220 (in other words, the plurality of solar cells 210 are spaced apart from each other by the predetermined spacing distance S in the first direction). For example, the predetermined spacing distance S is less than 3 mm. In other embodiments, the predetermined spacing distance S may be less than 2.8 mm, 2.6 mm, or 2.4 mm, and the extent of the predetermined spacing distance S may be adjusted according to the output power and/or heat dissipation of the overall solar battery. The horizontal interval lines are solar cell main grid lines 213. The total number of solar cells 210 included in each solar battery string group 220 does not exceed 100, which effectively prevents the output voltage of each solar battery string group 220 from being too high. In other embodiments, the total number of solar cells 210 may also be 90, 80, or less for reducing the output voltage of the solar battery string group 220. In this manner, the total number of solar cells 210 is adjusted according to the light intensity or the length of daytime irradiation in each region, which effectively maintains the safety of electricity consumption of the solar module of the present disclosure, and changes the total number of solar cells 210 in the solar battery string group 220 in accordance with the loaded electricity consumption.

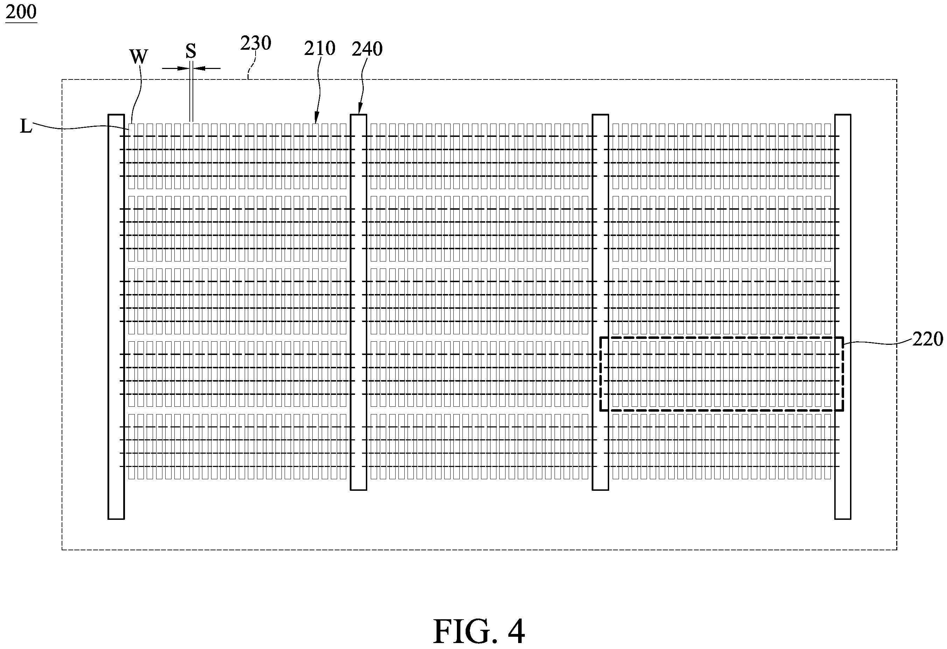

FIG. 4 is a schematic diagram of a welding method of the solar battery string group and the bus strip according to the present disclosure. A solar module 200 of the present disclosure includes solar cells 210, solar battery string groups 220, a carrier plate 230 and bus strips 240. The carrier plate 230 (indicated by a rectangular dotted line in FIG. 4) includes a transparent front cover and a transparent back cover. The front cover and the back cover are made of transparent material, such as glass or resin. An adhesive intermediate film is included between the front cover, the back cover and the plurality of solar battery string groups 220 to protect the solar cells 210 and the solar battery string groups 220 to prevent wear. In the solar module 200, the plurality of solar battery string groups 220 are pressed in a series/parallel manner between the front cover and the back cover via the plurality of bus strips 240. In other words, the solar battery string groups 220 can be connected in series or in parallel to form the circuit structure of the solar module 200.

In one embodiment, in terms of the circuit structure of the solar module 200, the solar battery string groups 220 on both sides of each bus strip 240 are connected in series, and the solar battery string groups 220 are connected in parallel between each two bus strips 240. For example, each solar battery string group 220 can be regarded as a battery structure, wherein on the left and right sides of a single bus strip 240 are battery structures in series in which positive electrodes are connected to negative electrodes, and between the two bus strips 240 are battery structures in parallel in which the positive electrodes are connected to the positive electrodes and the negative electrodes are connected to the negative electrodes. In this way, an electrical connection method between the bus strips 240 and the solar battery string groups 220 can adjust the output voltage of the overall solar module 200 and enhance electrical safety. In one embodiment, after the bus strips 240 and all the solar battery string groups 220 are welded, they are heated and laminated together with the front cover glass, the back cover glass and the adhesive intermediate film, so that a see-through solar module laminate as shown in FIG. 4 can be formed.

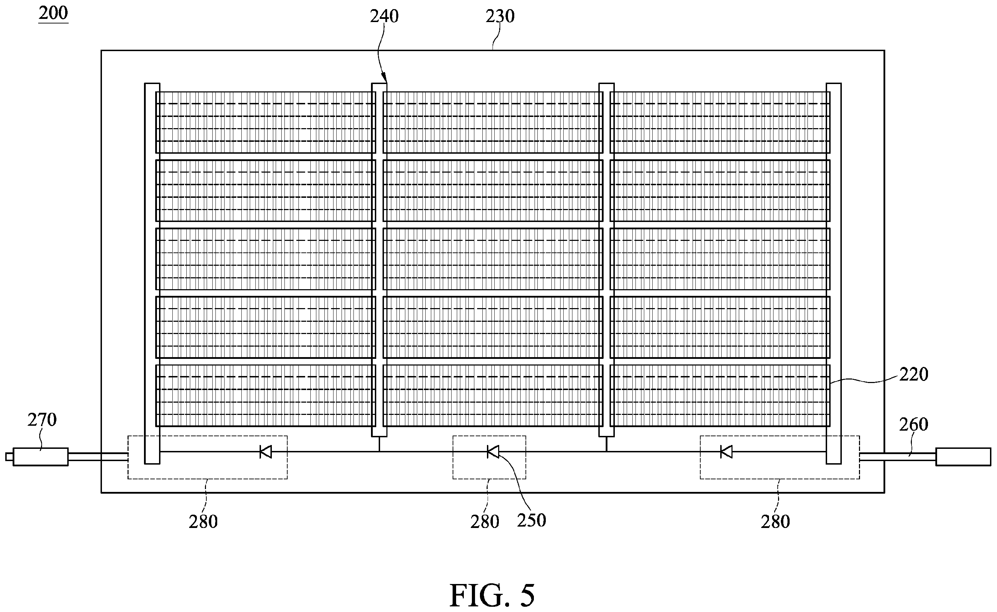

Please refer to FIG. 4 and FIG. 5 at the same time. FIG. 5 is a schematic diagram of the present disclosure applied to a see-through silicon crystal solar module, wherein the solar module 200 also includes at least one bypass diode 250, a cable 260, a terminal 270 and junction boxes 280. The cable 260 is electrically connected to one end of at least one bypass diode 250. The terminal 270 is electrically connected to the other end of at least one bypass diode 250. The bypass diode 250 is disposed inside the junction box 280 to protect the electrical safety of the junction box 280. Each bypass diode 250 is electrically connected between two bus strips 240. In one embodiment, in four vertical bus strips 240, the same end of each bus strip 240 is connected to the bypass diode 250, and a plurality of bypass diodes 250 may be called a first bypass diode, a second bypass diode and a third bypass diode from right to left, wherein the positive electrode of the first bypass diode (i.e., one end of at least one bypass diode 250) is electrically connected to the cable 260, the negative electrode of the first bypass diode is electrically connected to the positive electrode of the second bypass diode, the negative electrode of the second bypass diode is electrically connected to the positive electrode of the third bypass diode, and the negative electrode of the third bypass diode (i.e., the other end of at least one bypass diode 250) is electrically connected to the terminal 270.

To sum up, in the present disclosure, a plurality of bus strips are arranged in the carrier plate of the solar module area to protect the solar cells. On the left and right sides of the bus strip are battery structures in series in which positive electrodes are connected to negative electrodes, and between the two bus strips are battery structures in parallel in which the positive electrodes are connected to the positive electrodes and the negative electrodes are connected to the negative electrodes, so that the output voltage and current requirements of a solar module can be met to increase the output power. At the same time, a bypass diode is welded between two bus strips to protect each solar battery string group and prevent the solar module from overheating.

The foregoing embodiments are provided for the purpose of illustrating the principles and effects of the present disclosure, rather than limiting the present disclosure. Anyone skilled in the art can modify and alter the above embodiments without departing from the spirit and scope of the present disclosure. Therefore, the scope of protection with regard to the present disclosure should be as defined in the accompanying claims listed below.

## Claims

1. A solar module, comprising:
a plurality of solar cells, wherein the plurality of solar cells are welded and connected in series to define a plurality of solar battery string groups, and the plurality of solar cells are connected in series with a predetermined spacing distance therebetween in a first direction to form each of the plurality of solar battery string groups, wherein a width of each of the plurality of solar cells in the first direction is a first length, a length of each of the plurality of solar cells in a second direction is a second length, and a ratio of the second length to the first length is greater than 10; and
a carrier plate including a front cover and a back cover, wherein the plurality of solar battery string groups are pressed in series or in parallel between the front cover and the back cover via a plurality of bus strips, wherein the plurality of solar battery string groups on both sides of each of the plurality of bus strips are connected in series, and the plurality of solar battery string groups are connected in parallel between any two of the plurality of bus strips.

2. The solar module of claim 1, wherein the front cover, the back cover and the plurality of solar battery string groups have an adhesive intermediate film therebetween.

3. The solar module of claim 1, wherein the front cover and the back cover are made of transparent material.

4. The solar module of claim 3, wherein the transparent material is glass or resin.

5. The solar module of claim 1, wherein the first length is greater than 7 mm.

6. The solar module of claim 1, wherein a total number of the plurality of solar cells in each of the plurality of solar battery string groups does not exceed 100.

7. The solar module of claim 1, wherein the predetermined spacing distance is less than 3 mm.

8. The solar module of claim 1, further comprising at least one bypass diode electrically connected between any two of the plurality of bus strips.

9. The solar module of claim 8, further comprising a cable electrically connected to one end of the at least one bypass diode.

10. The solar module of claim 9, further comprising a terminal electrically connected to the other end of the at least one bypass diode.
